# FASCICULE DE BREVET EUROPEEN

(11) **EP 2 513 977 B1**
(45) Date de publication et mention de la délivrance du brevet: **04.03.2015**
(21) Numéro de dépôt: 10788361.3
(22) Date de dépôt: 28.10.2010
(51) Int. Cl.: H01L 31/05, H01L 31/052

(54) **Module photovoltaïque à connexion électrique présentant une fonction optique**
PV-Modul mit elektrischem Anschluss welcher eine optische Funktion aufweist
Photovoltaic module comprising an electrical connection having an optical function

(30) Priorité: 14.12.2009 FR 0958916
(43) Date de publication de la demande: 24.10.2012
(73) Titulaire: Commissariat à l'Énergie Atomique et aux Énergies Alternatives, 75015 Paris (FR)
(72) Inventeur: GERRITSEN, Eric, F-38190 Bernin (FR); THONY, Philippe, F-38380 Entre-deux-Guiers (FR)
(74) Mandataire: Vuillermoz, Bruno
(86) Numéro de dépôt international: PCT/FR2010/052315
(87) Numéro de publication internationale: WO 2011/080429

(56) Documents cités:
- US-A1- 2005 139 252
- US-A1- 2006 266 407
- US-A1- 2008 185 033

## Description

### DOMAINE TECHNIQUE

L'invention concerne un module photovoltaïque apte à transformer les photons de rayons lumineux incidents en énergie électrique. Elle concerne plus spécifiquement la connectique entre cellules photovoltaïques d'un même module.

### ETAT ANTERIEUR DE LA TECHNIQUE

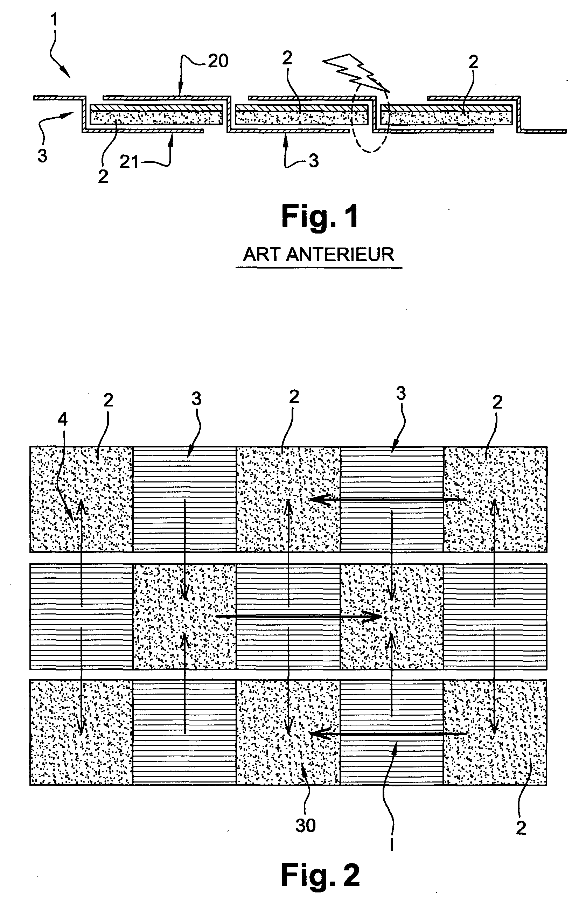

De manière générale un module photovoltaïque est formé d'une pluralité de cellules photovoltaïques **2** présentant chacune une face avant **20** et une face arrière **21.** Ces cellules photovoltaïques **2** peuvent être de type monofacial, c'est-à-dire présentant uniquement une face active, ou de type bifaciale, c'est-à-dire présentant une face avant active et une face arrière active, chacune des faces actives étant apte à collecter et à transformer en énergie électrique des photons de rayons lumineux incidents arrivant sur ces faces actives. Ces cellules photovoltaïques **2** sont disposées en présentant un espacement les séparant les unes des autres, et sont connectées électriquement en série entre elles, grâce à des moyens de connexion **3** passant de la face avant **20** d'une cellule à la face arrière **21** de la cellule adjacente, comme illustré sur la figure 1.

Le document US-A-2006/0266407 montre un module photovoltaïque connu.

La connexion électrique entre les cellules photovoltaïques n'est pas optimale du fait de la déformation subie par ces moyens de connexions. Un tel agencement de ces moyens de connexion nécessite de prévoir un espacement important entre les cellules, diminuant dès lors la surface active du panneau en résultant. A cet effet, on a proposé la mise en oeuvre de connexions planaires, qui cependant écrantent toujours une partie de la face avant des cellules. Au demeurant, un espacement entre lesdites cellules demeure nécessaire.

Dans ce contexte, la présente invention a pour but de proposer un autre module photovoltaïque exempt de cette limitation précédemment évoquée. L'invention a notamment pour but de proposer un module photovoltaïque qui offre un meilleur rendement électrique pour une surface donnée de dispositif ou de module.

### EXPOSE DE L'INVENTION

L'invention concerne à cet effet un module photovoltaïque comprenant une pluralité de cellules photovoltaïques connectées électriquement en série via des moyens de connexions intégrant des conducteurs électriques. Selon l'invention, chaque moyen de connexion comprend un dispositif optique présentant un comportement optique de type diffractif en réflexion ou en transmission. En outre, selon l'invention, chaque moyen de connexion est constitué d'une feuille réalisée en un matériau transparent aux rayons incidents contenant au moins un réseau de fils conducteurs électriques.

En d'autres termes, l'invention consiste à utiliser les connexions électriques entre les cellules comme dispositif optique. Les rayons redirigés par les dispositifs optiques peuvent notamment êtres utilisées pour augmenter le rendement électrique des cellules. Ainsi donc, alors même que de façon standard, la connectique occupe une partie de la surface active des cellules, surface qui est donc perdue en termes de rendement, l'invention prend le parti inhabituel d'augmenter cette surface « perdue » tout en lui conférant une fonction optique afin de ramener des photons vers les cellules et ainsi compenser la perte de surface active.

En outre, le dispositif optique peut présenter simultanément différentes fonctions optiques, telles que par exemple transparence et diffraction.

Avantageusement, la face avant de chaque cellule est connectée à la face avant d'une cellule adjacente, et la face arrière de ladite cellule est connectée à la face arrière d'une autre cellule adjacente.

Ainsi, la connexion électrique est de type planaire, ce qui facilite les procédés de fabrication.

De préférence, chaque moyen de connexion présente en outre un comportement optique apte à laisser passer tout ou partie des photons de rayons lumineux incidents. Par exemple, le moyen de connexion peut être transparent pour certaines longueurs d'onde.

Selon un mode de réalisation de l'invention, le réseau de fils conducteurs présente un motif apte à envoyer les rayons lumineux diffractés dans une direction perpendiculaire à la direction de circulation du courant électrique entre deux cellules photovoltaïques adjacentes connectées entre elles.

Chaque cellule peut présenter une face avant active et une face arrière active, et le module photovoltaïque peut en outre comprendre une plaque arrière disposée en regard des faces arrières des cellules, ladite plaque arrière présentant des zones réfléchissantes aptes à envoyer les photons incidents en direction des faces arrières des cellules.

Par exemple, la plaque arrière peut en outre présenter des zones aptes à laisser passer tout ou partie des rayons lumineux. La plaque arrière peut être réalisée en un matériau transparent.

### BREVE DESCRIPTION DES DESSINS

D'autres caractéristiques et avantages de l'invention ressortiront clairement de la description qui en est faite ci-après, à titre indicatif et nullement limitatif, en référence aux dessins annexés, dans lesquels :
- la figure 1 est une vue schématique partielle en section d'un module photovoltaïque de l'art antérieur ;
- la figure 2 est une vue schématique partielle en plan d'un module photovoltaïque comprenant des moyens de connexion électrique présentant un motif selon un mode de réalisation de l'invention ;
- la figure 3 est une vue schématique partielle en plan d'un module photovoltaïque comprenant des moyens de connexion électrique présentant un autre motif selon un autre mode de réalisation de l'invention ;
- la figure 4 est une vue schématique d'un autre motif des moyens de connexion électrique selon un autre mode de réalisation de l'invention ;
- la figure 5 est une vue schématique d'un autre motif des moyens de connexion électrique selon un autre mode de réalisation de l'invention ;
- la figure 6 est une vue schématique partielle en section d'un module photovoltaïque selon un autre mode de réalisation de l'invention ;
- la figure 7 est une vue schématique partielle en plan du module photovoltaïque de la figure 6 ;
- la figure 8 est une vue schématique partielle en section du module photovoltaïque intégrant une plaque arrière munie de moyen réflectif selon un mode de réalisation de l'invention ; et
- la figure 9 est une vue schématique partielle en section du module photovoltaïque intégrant une plaque arrière munie de moyen réflectif selon un autre mode de réalisation de l'invention.

### EXPOSE DETAILLE DE MODES DE REALISATION DE L'INVENTION

Selon l'invention, un module photovoltaïque **1** comprend une pluralité de cellules photovoltaïques **2** connectées électriquement en série via des moyens de connexions **3** présentant chacun un comportement optique. Chaque moyen de connexion **3** est en l'espèce constitué d'une feuille réalisée en un matériau transparent ou semi-transparent par rapport aux rayons incidents, et contenant des fils conducteurs **30,** par exemple de dimension nanométrique.

Ce comportement optique peut être de type diffractif en réflexion ou en transmission.

Dans un mode de réalisation de l'invention, et en référence à la figure 2, les fils conducteurs **30** d'un moyen de connexion **3** sont agencés espacés des uns des autres, parallèlement entre eux et parallèlement à une direction de circulation I d'un courant électrique. Du fait de l'espacement entre les fils conducteurs, le moyen de connexion **3** électrique se comporte comme un réseau de diffraction pour les rayons lumineux incidents. Les rayons diffractés **4** sont envoyés dans une direction perpendiculaire aux fils conducteurs ou à la direction de circulation I du courant électrique. Dans ce mode de réalisation, le ratio de la surface occupée par les cellules sur celle des moyens de connexion peut être égal à 1.

Une telle structure peut être réalisée par gravure dans des feuilles de polymères transparents recouvertes d'une couche mince d'un métal conducteur tel que aluminium ou cuivre ou argent. Les fils conducteurs peuvent également être obtenus par impression sur les feuilles de polymères à l'aide d'une encre conductrice.

Selon une autre solution technique, on met en oeuvre un matériau conducteur électrique, et on lui confère une propriété optique par structuration de sa surface. Ainsi, selon la forme, l'espacement, et la répétition des motifs, la surface du matériau devient un réseau de diffraction.

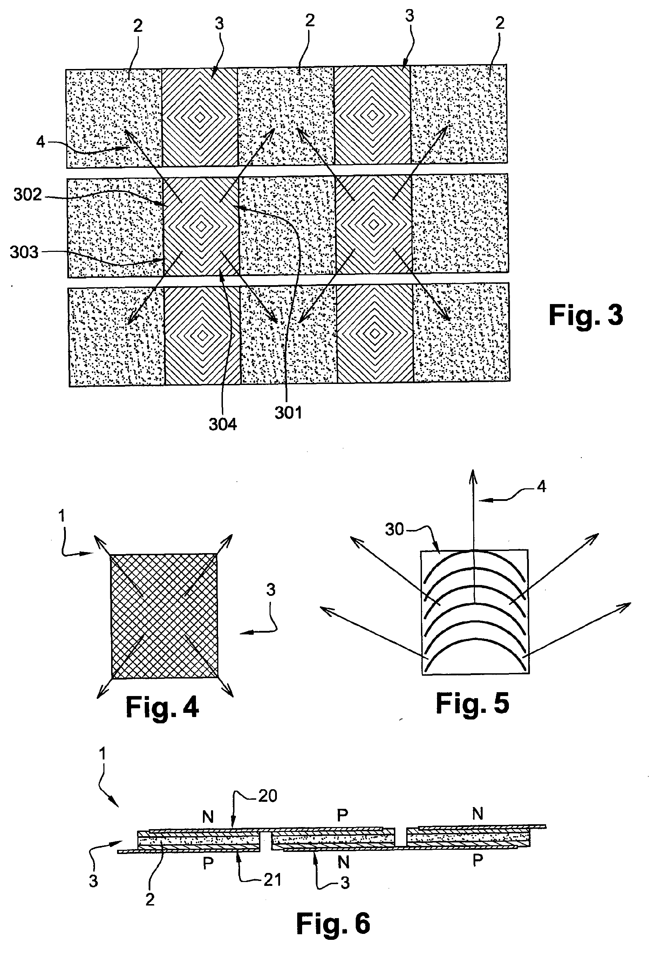

Selon un autre mode de réalisation de l'invention et en référence à la figure 3, les fils conducteurs **30** d'un moyen de connexion **3** sont agencés selon une configuration dite en arête de poisson ou « fishbone ». En d'autres termes, le moyen de connexion comprend quatre groupes de fils conducteurs :
- un premier groupe **301** de fils conducteurs agencés parallèlement entre eux, et orientés selon un angle de 45° par rapport à la direction de circulation I du courant électrique ;
- un deuxième groupe **302** de fils conducteurs agencé symétriquement au premier groupe **301** par rapport à un premier axe perpendiculaire à la direction de circulation 1 du courant électrique, ledit axe étant parallèle aux faces des cellules ;
- un troisième groupe **303** de fils conducteurs agencés symétriquement au deuxième groupe **302** par rapport à un deuxième axe perpendiculaire audit premier axe, lesdits premier et deuxième axes étant coplanaires ;
- enfin un quatrième groupe **304** de fils conducteurs symétrique au premier groupe **301** par rapport au deuxième axe.

Dans ce mode de réalisation, chacun des groupes **301, 302, 303, 304** se comporte comme un réseau de diffraction et les rayons diffractés sont envoyés dans des directions sensiblement perpendiculaires aux fils conducteurs. Cette configuration confère une plus grande flexibilité quant à la disposition relative des cellules, ainsi qu'à leur forme.

Selon un autre mode de réalisation de l'invention et en référence à la figure 4, les fils conducteurs d'un moyen de connexion peuvent être agencés de manière à former des grilles, ce qui présente le même avantage qu'évoqué ci-dessus, et ce qui permet ainsi d'optimiser la conduction électrique.

Selon un autre mode de réalisation de l'invention et en référence à la figure 5, les fils conducteurs d'un moyen de connexion peuvent former des lignes elliptiques ou circulaires. Cette configuration permet ainsi d'améliorer la flexibilité de l'agencement.

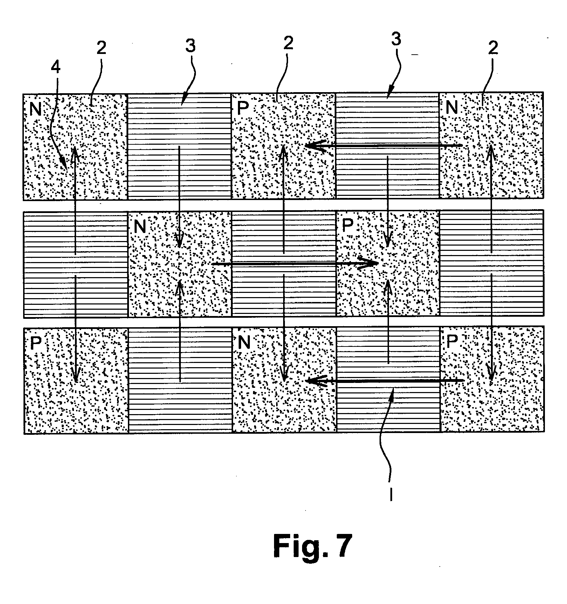

Selon un autre mode de réalisation de l'invention et en référence aux figures 6 et 7, les cellules sont de type bifacial. Elles sont notamment réalisées par exemple à partir de couches de silicium, et présentent une face active dopée P et une autre face active dopée N. Ces cellules sont connectées en série via les moyens de connexion **3** utilisés dans le mode de réalisation de la figure 2 et sont agencées de sorte que la face avant de type P d'une cellule est coplanaire avec la face avant de type N d'une cellule adjacente. En outre, la face avant de chaque cellule est connectée à la face avant d'une cellule adjacente de dopage opposé, et la face arrière de ladite cellule est connectée à la face arrière d'une autre cellule adjacente, là encore, de dopage opposé.

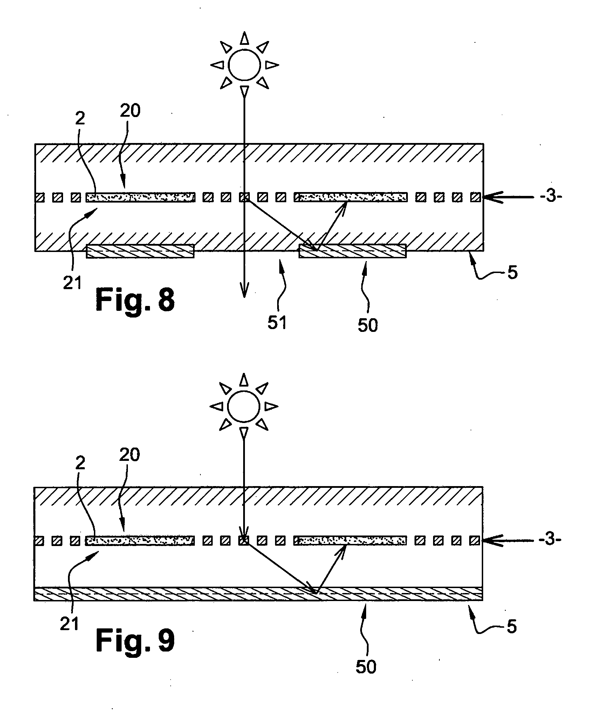

Par ailleurs, afin d'augmenter le rendement électrique du module photovoltaïque, chaque moyen de connexion **3** peut en outre présenter un comportement optique apte à laisser passer tout ou partie des photons de rayons lumineux incidents, comme illustré sur les figures 8 et 9. En outre, le module photovoltaïque peut comprendre une plaque arrière **5** disposée en regard des faces arrières **21** des cellules, ladite plaque arrière étant munie de zones réfléchissantes **50** aptes à renvoyer les photons incidents l'atteignant en direction des faces arrières **21** des cellules. Comme illustré sur la figure 8, il est également possible de prévoir des zones transparentes **51** au niveau de la plaque arrière **5** afin de laisser passer la lumière naturel pour éclairer une pièce.

Une autre alternative peut également consister à munir la plaque arrière de dispositif réflectif tel que miroir, ou de dispositif réfractif tel que prisme ou lentille, ou encore de dispositif de type concentrateur.

Il ressort de ce qui précède que l'originalité de l'invention réside dans le fait que les moyens de connexion électrique entre les cellules photovoltaïques présentent un comportement optique vis-à-vis des rayons incidents. Ces moyens de connexion peuvent être transparents pour laisser passer tout ou partie des rayons lumineux qui peuvent ensuite être utilisés pour augmenter le rendement électrique des cellules photovoltaïques grâce notamment à des moyens réflectifs tels que des miroirs disposés au niveau de la plaque arrière du module photovoltaïque pour renvoyer les photons vers les faces arrières des cellules. Ces moyens peuvent également être de type diffractif, c'est-à-dire que les rayons lumineux ont une trajectoire modifiée.

En augmentant la surface entre les cellules et en exploitant la face arrière des cellules bifaciales, il est possible d'augmenter le rendement électrique tout en diminuant la surface des cellules, et donc le coût de fabrication.

Par ailleurs, en redirigeant certains rayons lumineux tels que les rayons infrarouges vers l'extérieur du module photovoltaïque, il est possible de réaliser un refroidissement des cellules.

## Revendications

1. Module photovoltaïque (1) comprenant une pluralité de cellules photovoltaïques (2) connectées électriquement en série via des moyens de connexion (3) intégrant des conducteurs électriques, ***caractérisé* en ce que** chaque moyen de connexion (3) comprend un dispositif optique présentant un comportement optique de type diffractif en réflexion ou en transmission, et chaque moyen de connexion (3) est de type planaire et est constitué d'une feuille réalisée en un matériau transparent aux rayons incidents contenant au moins un réseau de fils conducteurs électrique (30).

2. Module photovoltaïque selon la revendication 1, ***caractérisé* en ce que** le dispositif optique présente simultanément différentes fonctions optiques, et notamment transparence et diffraction.

3. Module photovoltaïque selon l'une des revendications 1 et 2, ***caractérisé* en ce que** la face avant (20) de chaque cellule photovoltaïque (2) est connectée à la face avant (20) d'une cellule photovoltaïque (2) adjacente, et la face arrière (21) de ladite cellule (2) est connectée à la face arrière (21) d'une autre cellule (2) adjacente.

4. Module photovoltaïque selon la revendication 1 à 3, ***caractérisé* en ce que** chaque moyen de connexion (3) présente au moins un comportement optique apte à laisser passer tout ou partie des photons de rayons lumineux incidents.

5. Module photovoltaïque selon la revendication 1 à 4, ***caractérisé* en ce que** le réseau de fils conducteurs électriques (30) présente un motif apte à envoyer les rayons lumineux diffractés dans une direction perpendiculaire à la direction de circulation (I) du courant électrique entre deux cellules photovoltaïques adjacentes connectées entre elles.

6. Module photovoltaïque selon l'une des revendications 1 à 4, ***caractérisé* en ce que** chaque moyen de connexion est constitué d'un matériau conducteur électrique structuré afin de réaliser un réseau optique de diffraction.

7. Module photovoltaïque selon l'une des revendications 1 à 6, ***caractérisé* en ce que** chaque cellule photoélectrique (2) présente une face avant (20) active et une face arrière (21) active, et **en ce que** le module photovoltaïque (1) comprend en outre une plaque arrière (5) disposée en regard des faces arrières (21) des cellules (2), ladite plaque arrière (5) présentant des zones réfléchissantes (50) aptes à envoyer les photons incidents en direction des faces arrières (21) des cellules (2).

8. Module photovoltaïque selon la revendication 7, ***caractérisé* en ce que** la plaque arrière (5) présente en outre des zones transparentes (51) aptes à laisser passer les rayons lumineux incidents.

## Patentansprüche

1. Photovoltaikmodul (1), mehrere Photovoltaikzellen (2) umfassend, die über elektrische Leiter integrierende Verbindungseinrichtungen (3) elektrisch in Reihe geschaltet sind, **dadurch gekennzeichnet, dass** jede Verbindungseinrichtung (3) eine optische Vorrichtung umfasst, die ein bei Reflexion oder Transmission lichtbeugendes optisches Verhalten aufweist, und jede Verbindungseinrichtung (3) vom planaren Typ ist und aus einem für einfallende Strahlen transparenten Material hergestellten Flächenkörper besteht, der mindestens ein Netz elektrischer Leiterdrähte (30) enthält.

2. Photovoltaikmodul nach Anspruch 1, **dadurch gekennzeichnet, dass** die optische Vorrichtung gleichzeitig verschiedene optische Funktionen und insbesondere Transparenz und Lichtbeugung aufweist.

3. Photovoltaikmodul nach einem der Ansprüche 1 und 2, **dadurch gekennzeichnet, dass** die Vorderseite (20) jeder Photovoltaikzelle (2) mit der Vorderseite (20) einer benachbarten Photovoltaikzelle (2) verbunden ist, und die Rückseite (2) dieser Zelle (2) mit der Rückseite (21) einer anderen benachbarten Zelle (2) verbunden ist.

4. Photovoltaikmodul nach einem der Ansprüche 1 bis 3, **dadurch gekennzeichnet, dass** jede Verbindungseinrichtung (3) mindestens ein optisches Verhalten aufweist, das in der Lage ist, alle oder einen Teil der Photonen von einfallenden Lichtstrahlen durchzulassen.

5. Photovoltaikmodul nach einem der Ansprüche 1 bis 4, **dadurch gekennzeichnet, dass** das Netz aus elektrischen Leiterdrähten (30) ein Muster aufweist, das in der Lage ist, die gebeugten Lichtstrahlen in eine zur Zirkulationsrichtung (I) des elektrischen Stroms zwischen zwei miteinander verbundenen, benachbarten Photovoltaikzellen senkrechten Richtung zu schicken.

6. Photovoltaikmodul nach einem der Ansprüche 1 bis 4, **dadurch gekennzeichnet, dass** jede Verbindungseinrichtung aus einem elektrisch leitenden Material besteht, das strukturiert ist, um ein optisches Beugungsgitter zu schaffen.

7. Photovoltaikmodul nach einem der Ansprüche 1 bis 6, **dadurch gekennzeichnet, dass** jede Photovoltaikzelle (2) eine aktive Vorderseite (20) und eine aktive Rückseite (21) aufweist, und dass das Photovoltaikmodul (1) darüber hinaus eine Rückplatte (5) umfasst, die den Rückseiten (21) der Zellen (2) zugewandt angeordnet ist, wobei die Rückplatte (5) reflektierende Bereiche (50) aufweist, die in der Lage sind, die einfallenden Photonen in Richtung der Rückseiten (21) der Zellen (2) zu schicken.

8. Photovoltaikmodul nach Anspruch 7, **dadurch gekennzeichnet, dass** die Rückplatte (5) darüber hinaus transparente Bereiche (51) aufweist, die in der Lage sind, die einfallenden Lichtstrahlen durchzulassen.

## Claims

1. A photovoltaic module (1) comprising a plurality of photovoltaic cells (2) electrically connected in series via connection means (3) comprising electrical conductors, **characterised in that** each connection means (3) comprises an optical device having a reflection-diffractive or transmission-diffractive optical behaviour, and each connection means (3) consists of a sheet formed from a material that is transparent to incident rays containing at least one network of electrical conductor wires (30).

2. The photovoltaic module as claimed in claim 1, **characterised in that** the optical device has various optical functions simultaneously, and in particular transparency and diffraction.

3. The photovoltaic module as claimed in one of claims 1 and 2, **characterised in that** the front face (20) of each photovoltaic cell (2) is connected to the front face (20) of an adjacent photovoltaic cell (2), and the rear face (21) of said cell (2) is connected to the rear face (21) of another adjacent cell (2).

4. The photovoltaic module as claimed in claim 1 to 3, **characterised in that** each connection means (3) has at least one optical behaviour suitable for letting through all or part of the incident light photons.

5. The photovoltaic module as claimed in claim 1 to 4, **characterised in that** the network of electrical conductor wires (30) has a design that can send the diffracted light rays in a direction perpendicular to the direction of flow (I) of the electric current between two interconnected adjacent photovoltaic cells.

6. The photovoltaic module as claimed in one of claims 1 to 4, **characterised in that** each connection means consists of an electrically conductive material structured so as to produce an optical diffraction network.

7. The photovoltaic module as claimed in one of claims 1 to 6, **characterised in that** each photovoltaic cell (2) has an active front face (20) and an active rear face (21), and **in that** the photovoltaic module (1) further comprises a rear plate (5) placed opposite the rear faces (21) of the cells (2), said rear plate (5) having reflecting zones (50) that can send the incident photons towards the rear faces (21) of the cells (2).

8. The photovoltaic module as claimed in claim 7, **characterised in that** the rear plate (5) additionally has transparent zones (51) that can let through incident light rays.
